# EUROPEAN PATENT APPLICATION

(11) **EP 4 528 733 A1**
(43) Date of publication of application: **26.03.2025**
(21) Application number: 22942777.8
(22) Date of filing: 26.10.2022
(51) Int. Cl.: G11B 33/02, G11B 33/08, G06F 1/16, B65D 81/02

(54) **FIXING DEVICE AND STORAGE DEVICE**

(30) Priority: 16.05.2022 JP 2022080371
(71) Applicant: i-PRO Co., Ltd., Tokyo 108-6014 (JP)
(72) Inventor: FUKAMIZU Takahiro, Tokyo 108-6014 (JP)
(74) Representative: Eisenführ Speiser
(86) International application number: PCT/JP2022/040042
(87) International publication number: WO 2023/223574

(57) **Abstract**

This fixing device comprises: a case body that has an accommodation space for accommodating an object to be fixed on the inside of circumferential wall parts standing from a bottom wall part; a pair of retaining parts that are rotatably connected to the case body and bridge over an upper opening of a circumferential wall part on the opposite side of the bottom wall part; and a connecting part that connects the distal rotational ends of the pair of retaining parts. The circumferential wall parts include a front wall part and a rear wall part opposing each other across the accommodation space. The pair of retaining parts have curved surfaces protruding into the accommodation space, and the proximal rotational end sides thereof are connected to the rear wall part by a hinge part. The connecting part has a lock claw that engages with the front wall part from the inside of the accommodation space.

## Description

### TECHNICAL FIELD

The present disclosure relates to a fixing device and a storage device.

### BACKGROUND ART

Patent Literature 1 discloses a protector for holding a hard disk device (HDD) between a first outer shell body and a second outer shell body that are placed in a facing state. The protector includes: a buffer body that is disposed on an inner surface of each of the first and second outer shell bodies and that comes into contact with a surface of the HDD when the first outer shell body and the second outer shell body are placed in a facing state; a lock unit for locking the first outer shell body and the second outer shell body in a facing state; an attachment member that is provided on both or one of the first outer shell body and the second outer shell body and that is used when the protector is attached to another object while holding the HDD; and a displacement restraint member that is displaceable from a first position to a second position and that does not press the HDD held between the first outer shell body and the second outer shell body at the first position and presses the held HDD against one of the first outer shell body and the second outer shell body at the second position.

### CITATION LIST

### PATENT LITERATURE

Patent Literature 1: Japan Patent No. 3408774

### SUMMARY OF INVENTION

### TECHNICAL PROBLEM

The protector according to Patent Literature 1 includes two fixing arms each having one engaging hole, and one locking body having two locking protrusions, which must be engaged with and disengaged from a base portion at a total of four engagement portions, which creates a problem that the process of attaching and detaching a protected body to the protector is complicated. In addition, since a locking body separate from the base portion is required, the number of components increases and a member cost increases. Further, since the locking body presses a central portion of an upper surface of the protected body against a base portion (one side) with one pressing portion, there is a concern that the upper surface of the protected body may separate from the buffer body of the fixing arm, which may cause rattling due to vibration and result in unstable fixing.

An object of the present disclosure is to facilitate attachment and detachment of a fixed object and to realize stable fixing of the fixed object with a low member cost.

### SOLUTION TO PROBLEM

The present disclosure provides a hard disk drive fixing device including: a case main body including, inside a peripheral wall portion standing from a bottom wall portion, an accommodation space configured to accommodate a fixed object; a pair of parallel retaining portions rotatably connected to the case main body and extending across an upper opening of the peripheral wall portion on a side opposite to the bottom wall portion; and a joint portion that couples rotational distal ends of the pair of parallel retaining portions, in which in the case main body, the peripheral wall portion includes a front wall portion and a rear wall portion facing each other with the accommodation space sandwiched therebetween, the pair of retaining portions each have a curved surface protruding into the accommodation space, and have a rotational proximal end connected to the rear wall portion by a hinge portion, and the joint portion includes a lock claw configured to be engaged with the front wall portion from an inside of the accommodation space.

### ADVANTAGEOUS EFFECTS OF INVENTION

According to the present disclosure, the fixed object can be easily attached and detached, and stable fixing of the fixed object can be realized with a low member cost.

### BRIEF DESCRIPTION OF DRAWINGS

FIG. 1 is a plan view of a hard disk drive fixing device according to a first embodiment in which a hard disk drive is accommodated in a fixing release state.
FIG. 2 is a perspective view of the hard disk drive fixing device illustrated in FIG. 1 with the hard disk drive removed.
FIG. 3 is a perspective view of the hard disk drive fixing device in a fixed state in which retaining portions are engaged with a case main body, as viewed from one side wall portion.
FIG. 4 is a perspective view of the hard disk drive fixing device in the fixed state in which the retaining portions are engaged with the case main body, as viewed obliquely from front of a front wall portion.
FIG. 5 is a perspective view of the hard disk drive fixing device according to the first embodiment in which the hard disk drive is accommodated in the fixing release state.
FIG. 6 is a front view of the hard disk drive fixing device according to the first embodiment in which the hard disk drive is accommodated in the fixed state.
FIG. 7 is a perspective view of the hard disk drive fixing device according to the first embodiment in which the hard disk drive is accommodated in the fixed state.
FIG. 8 is an enlarged view of a main portion illustrated in FIG. 7.
FIG. 9 is a plan view of a hard disk drive fixing device according to a modification in which a hard disk drive is removed.
FIG. 10 is a perspective view of the hard disk drive fixing device illustrated in FIG. 9 in which the hard disk drive is removed.
FIG. 11 is an enlarged view of a second hinge portion of the hard disk drive fixing device illustrated in FIG. 10.
FIG. 12 is a perspective view of the second hinge portion of the hard disk drive fixing device according to the modification as viewed from an outside of a rear wall portion.
FIG. 13 is a front view of the second hinge portion of the hard disk drive fixing device according to the modification as viewed from the outside of the rear wall portion.
FIG. 14 is a perspective view of the second hinge portion of the hard disk drive fixing device according to the modification as viewed from an outside of a peripheral wall portion.
FIG. 15 is a perspective view of the hard disk drive fixing device in a disengaged state in which retaining portions are not engaged with a case main body.
FIG. 16 is a perspective view of the hard disk drive fixing device in the disengaged state in which the retaining portions are not engaged with the case main body, as viewed from an outside of a front wall portion.

### DESCRIPTION OF EMBODIMENTS

Hereinafter, an embodiment that specifically discloses a fixing device and a storage device according to the present disclosure will be described in detail with reference to the drawings as appropriate. Detailed descriptions more than necessary may be omitted. For example, detailed description of already well-known matters and redundant description of substantially the same configuration may be omitted. This is to avoid redundancy of the following description and facilitate understanding of a person skilled in the art. The accompanying drawings and the following description are provided for a person skilled in the art to sufficiently understand the present disclosure, and are not intended to limit the subject matter described in the claims.

In a first embodiment to be described below, a hard disk drive fixing device for fixing a fixed object (for example, a hard disk drive. The same applies below.) is described as an example of the fixing device according to the present disclosure. The fixed object to be fixed by the fixing device may not be limited to the hard disk drive.

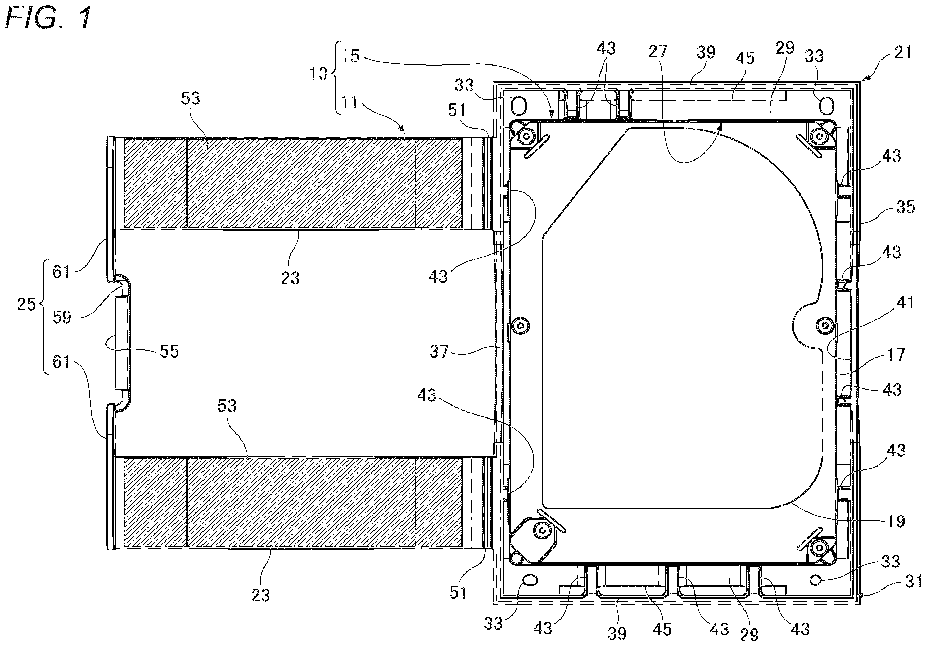

FIG. 1 is a plan view of a hard disk drive fixing device 11 according to the first embodiment in which a hard disk drive 15 is accommodated in a fixing release state. The hard disk drive fixing device 11 according to the first embodiment is mounted on, for example, a housing (not illustrated) of a storage device 13. The storage device 13 may be built in, for example, a personal computer (PC) or an audiovisual device, or may be externally connected thereto.

The storage device 13 according to the first embodiment includes the hard disk drive fixing device 11 and the hard disk drive 15 (HDD) to be fixed to the hard disk drive fixing device 11. The hard disk drive fixing device 11 is fixed to the housing (not illustrated) of the storage device 13.

The hard disk drive 15 is a flat hexahedron in which an upper surface and a lower surface (not illustrated) are substantially rectangular, and sides of the hard disk drive 15 in a housing height direction are sufficiently smaller than the other sides. The hard disk drive 15 accommodates a storage medium such as a magnetic disk inside a box-shaped casing (not illustrated) having an upper opening. In the casing accommodating the storage medium, the upper opening is closed by a lid member 17. The hard disk drive 15 includes a protrusion 19 on the upper surface according to a shape of the storage medium accommodated therein. That is, the upper surface of the hard disk drive 15 may not be a flat surface. The hard disk drive 15 has at least two types of sizes with different heights.

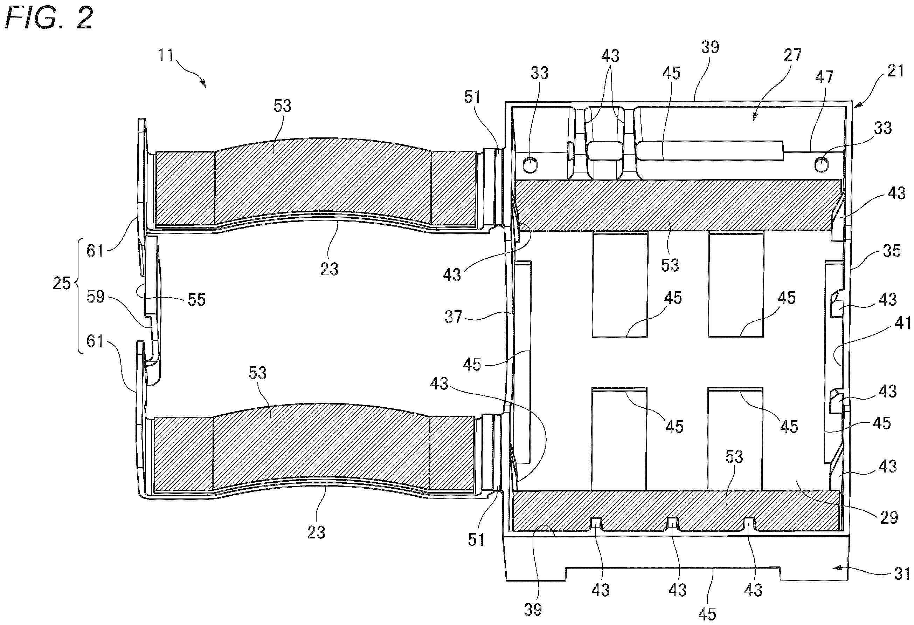

FIG. 2 is a perspective view of the hard disk drive fixing device 11 with the hard disk drive 15 removed. The hard disk drive fixing device 11 according to the first embodiment can be manufactured as a molded product including a case main body 21, a pair of retaining portions 23, and a joint portion 25. The hard disk drive fixing device 11 can be integrally molded by injection molding using polypropylene as a material, for example. The molding method is not limited thereto.

The case main body 21 includes, inside a peripheral wall portion 31 standing from a bottom wall portion 29, an accommodation space 27 for accommodating the hard disk drive 15. That is, the case main body 21 functions as a holding portion that holds the periphery of the hard disk drive 15. The bottom wall portion 29 is formed in a square shape in a plan view. In the first embodiment, the bottom wall portion 29 has a rectangular shape. At four corners of the bottom wall portion 29, screw holes 33 are drilled for screwing the case main body 21 to the housing (not illustrated) of the storage device.

The peripheral wall portion 31 includes a front wall portion 35 and a rear wall portion 37 facing each other with the accommodation space 27 sandwiched therebetween. The front wall portion 35 and the rear wall portion 37 are provided along long sides of the bottom wall portion 29 formed in a rectangular shape. Ends of the front wall portion 35 and the rear wall portion 37 are connected to each other by a pair of parallel side wall portions 39. The pair of parallel side wall portions 39 are provided along short sides of the bottom wall portion 29 formed in a rectangular shape. That is, in the case main body 21, the peripheral wall portion 31 is formed by the front wall portion 35, the rear wall portion 37, and the pair of parallel side wall portions 39 standing from sides of the bottom wall portion 29 formed in a square shape.

An inner wall surface 41 of the peripheral wall portion 31 is provided with a plurality of ribs 43 that protrude into the accommodation space 27 and come into contact with the fixed object. The rib 43 is formed in a small plate shape on the inner wall surface 41 of the peripheral wall portion 31, extends in a height direction (for example, a depth direction of the paper in FIG. 1), and has a plate thickness in a direction perpendicular to the height direction. Corners of an upper end of the rib 43 protruding into the accommodation space 27 are cut off to form an inclined guide surface for smoothly inserting the hard disk drive 15 into the accommodation space 27. For example, the inner wall surface 41 of the rear wall portion 37 is provided with two ribs 43, the inner wall surface 41 of the front wall portion 35 is provided with four ribs 43, the inner wall surface 41 of one side wall portion 39 is provided with three ribs 43, and the inner wall surface 41 of the other side wall portion 39 is provided with two ribs 43. The number and position of the ribs 43 are not limited thereto.

The case main body 21 has a plurality of (for example, four) vent holes 45 in the bottom wall portion 29. The vent hole 45 opens the accommodation space 27 to outside (that is, an inside of the housing of the storage device on which the hard disk drive fixing device 11 is mounted). The vent hole 45 is formed, for example, in a rectangular shape or the like, and a total of four vent holes 45, two vent holes 45 along the long side of the bottom wall portion 29 and two vent holes 45 along the short side of the bottom wall portion 29, are disposed. The vent hole 45 provided in the bottom wall portion 29 is formed with an opening area of about 1/3 to 1/2 of an area of the bottom wall portion 29. The opening area of the vent hole 45 is not limited to about 1/3 to 1/2 of the area described above.

The vent hole 45 is also formed in corner portions 47 at which the bottom wall portion 29 intersects with the peripheral wall portion 31. More specifically, the vent hole 45 is drilled in each of the four corner portions 47 at which four sides of the bottom wall portion 29 intersect with the peripheral wall portion 31. The vent hole 45 provided in the corner portion 47 is formed across the bottom wall portion 29 and the peripheral wall portion 31 by cutting out a part of each of the bottom wall portion 29 and the peripheral wall portion 31. In the case main body 21 according to the first embodiment, the vent hole 45 formed in the corner portion 47 is formed in a slit shape along each side.

A pair of ribs 43 are disposed apart from each other in the vent hole 45 provided in the corner portion 47 between the bottom wall portion 29 and the front wall portion 35. A lock claw of a joint portion 25 to be described later is inserted into a gap sandwiched between the pair of ribs 43.

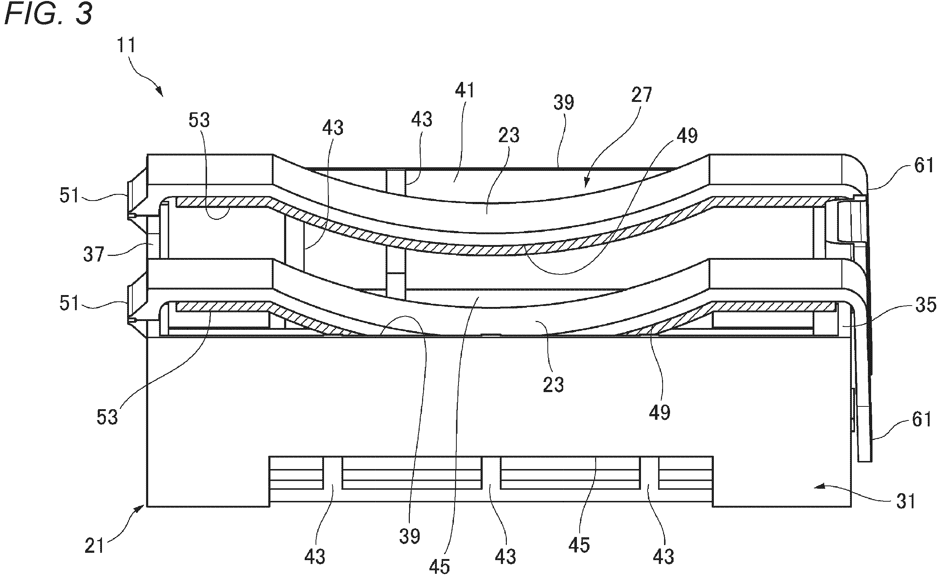

FIG. 3 is a perspective view of the hard disk drive fixing device 11 in a fixed state in which the retaining portions 23 are engaged with the case main body 21, as viewed from one side wall portion. The pair of retaining portions 23 are rotatably connected to the case main body 21. The pair of retaining portions 23 each have a curved surface 49 protruding into the accommodation space 27 in the fixed state (that is, a state in which the retaining portions 23 are engaged with the case main body 21. The same applies below.). That is, the retaining portion 23 has an arch shape extending across the rear wall portion 37 and the front wall portion 35, and in the fixed state, a protrusion part of the arch shape of the curved surface 49 comes into contact with and presses the hard disk drive 15 toward the bottom wall portion 29, thereby retaining the hard disk drive 15. A curvature (R value) of the curved surface 49 in the pair of retaining portions 23 is set such that even when an assumed height of the hard disk drive 15 is lowest, the protrusion part of the arch shape can come into contact with and retain the hard disk drive 15.

A rotational proximal end of each of the retaining portions 23 is connected to the rear wall portion 37 by a hinge portion 51 including a thin portion. The pair of hinge portions 51 are disposed, for example, in the vicinity of both ends of the rear wall portion 37 in a longitudinal direction. The retaining portion 23 is rotated about the hinge portion 51 and thus extends across the rear wall portion 37 and the front wall portion 35. The pair of retaining portions 23 extend across an upper opening of the peripheral wall portion 31 on a side opposite to the bottom wall portion 29. Each of the retaining portions 23 is formed in a plate shape elongated in a direction in which the retaining portion 23 extends across the rear wall portion 37 and the front wall portion 35.

As illustrated in FIG. 2, a cushion material 53 that comes into contact with the fixed object is adhered to at least a part of the bottom wall portion 29 and the retaining portion 23. The cushion material 53 can be made of an elastic sheet material having a predetermined thickness. The cushion material 53 is provided with an adhesive layer on an adhesive surface, for example. In the first embodiment, the cushion material 53 is formed in a rectangular shape along the respective side wall portions 39 on the front side and the back side of the bottom wall portion 29. The cushion material 53 is adhered to the entire surfaces of the pair of retaining portions 23 facing the bottom wall portion 29. For example, urethane rubber or silicone rubber may be used for the cushion material 53.

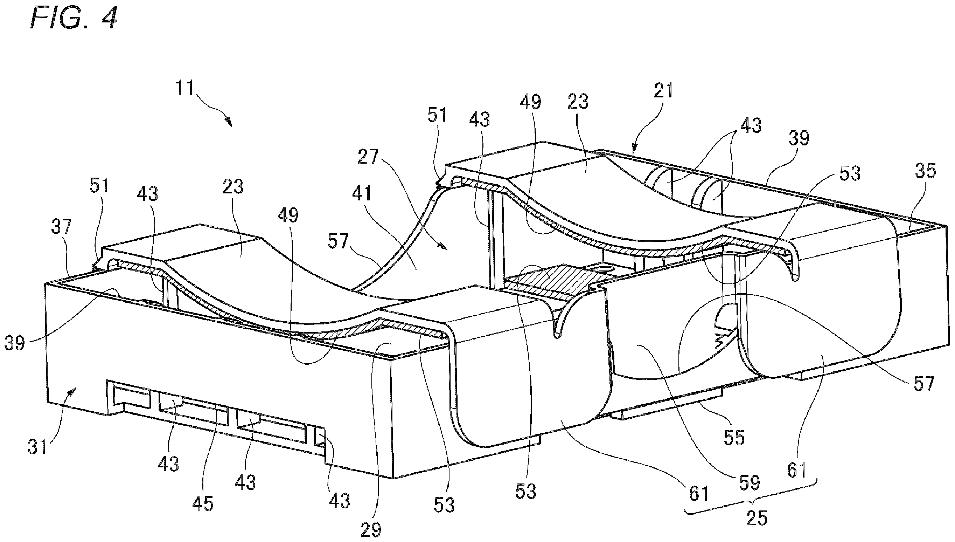

FIG. 4 is a perspective view of the hard disk drive fixing device 11 in the fixed state in which the retaining portions 23 are engaged with the case main body 21, as viewed obliquely from front of the front wall portion 35. The joint portion 25 couples rotational distal ends of the pair of parallel retaining portions 23 to each other. The joint portion 25 includes a lock claw 55 to be engaged with the front wall portion 35 from an inside of the accommodation space 27. The joint portion 25 can be engaged with (locked to) the front wall portion 35 of the case main body 21 via the lock claw 55 in the fixed state. A part of the front wall portion 35 of the case main body 21 to be engaged with the lock claw 55 is formed as a recessed portion 57 formed by cutting out by a concave curve from an upper portion. The recessed portion 57 is similarly formed on the rear wall portion 37.

The joint portion 25 is substantially parallel or parallel to the front wall portion 35 in a state in which the retaining portion 23 extends across the rear wall portion 37 and the front wall portion 35. The joint portion 25 includes, at a center in a direction along the front wall portion 35, an engaging plate portion 59 that extends downward at a right angle from the rotational distal end of the retaining portion 23 and is to be disposed inside the front wall portion 35. The lock claw 55 is provided at a lower end of a surface of the engaging plate portion 59 facing the front wall portion 35. Both sides of the joint portion 25 sandwiching the engaging plate portion 59 serve as engaging plate coupling portions 61 that are offset to an outside of the front wall portion 35. The pair of engaging plate coupling portions 61 couple the rotational distal ends of the respective retaining portions 23 and both sides of the engaging plate portion 59.

In the hard disk drive fixing device 11, the lock claw 55 is to be inserted into the vent hole 45 formed in the corner portion 47 between the bottom wall portion 29 and the front wall portion 35. The lock claw 55 inserted into the vent hole 45 is engaged with (locked to) a lower end surface of the front wall portion 35. The vent hole 45 formed in the corner portion 47 at which the bottom wall portion 29 intersects with the front wall portion 35 is formed to have a size including a flexible space for the lock claw 55 of the joint portion 25 to be engaged with the front wall portion 35.

Next, an operation of the hard disk drive fixing device according to the above first embodiment will be described.

The hard disk drive fixing device 11 according to the first embodiment includes the case main body 21 including, inside the peripheral wall portion 31 standing from the bottom wall portion 29, the accommodation space 27 for accommodating the fixed object; the pair of parallel retaining portions 23 rotatably connected to the case main body 21 and extending across the upper opening of the peripheral wall portion 31 on the side opposite to the bottom wall portion 29; and the joint portion 25 that couples the rotational distal ends of the pair of parallel retaining portions 23. The peripheral wall portion 31 includes the front wall portion 35 and the rear wall portion 37 facing each other with the accommodation space 27 sandwiched therebetween. The pair of retaining portions 23 each have the curved surface 49 protruding into the accommodation space 27, and have the rotational proximal end connected to the rear wall portion 37 by the hinge portion 51. The joint portion 25 includes the lock claw 55 to be engaged with the front wall portion 35 from the inside of the accommodation space 27.

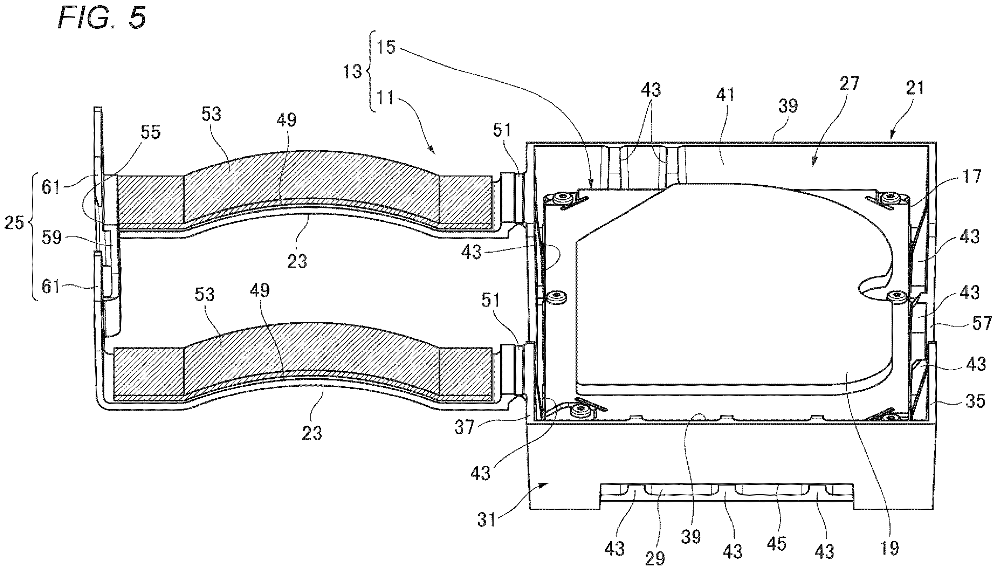

FIG. 5 is a perspective view of the hard disk drive fixing device 11 according to the first embodiment in which the hard disk drive is accommodated in the fixing release state. In the hard disk drive fixing device 11 according to the first embodiment, the case main body 21 includes the bottom wall portion 29 and the peripheral wall portion 31. The peripheral wall portion 31 standing from the bottom wall portion 29 surrounds the hard disk drive 15 placed on the bottom wall portion 29. The pair of parallel retaining portions 23 extending across the upper opening of the peripheral wall portion 31 on the side opposite to the bottom wall portion 29 are rotatably connected to the case main body 21. The rotational distal ends of the pair of parallel retaining portions 23 are coupled to each other by the joint portion 25. In the hard disk drive fixing device 11, the respective portions of the case main body 21, the retaining portion 23, and the joint portion 25 are molded integrally with a resin material or the like.

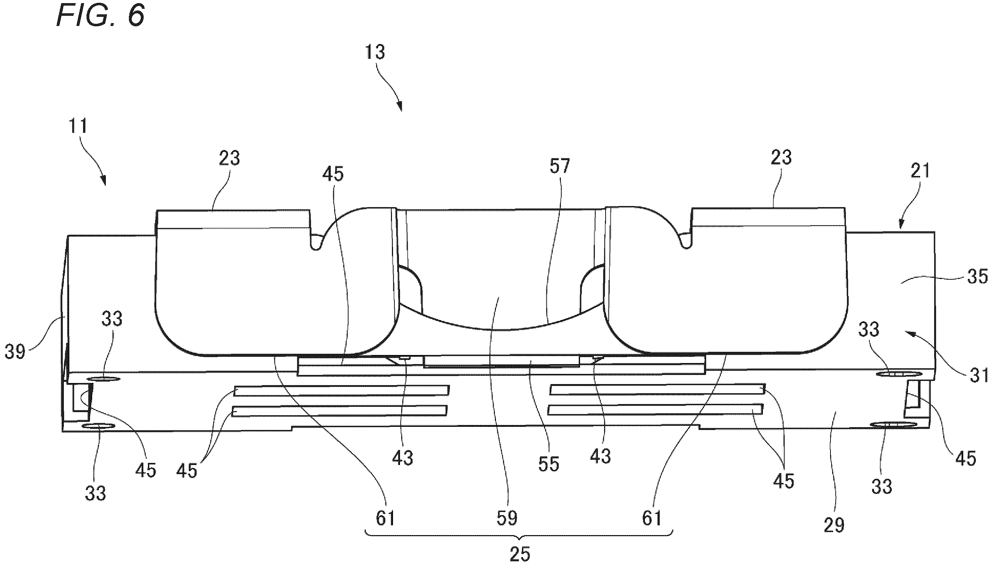

FIG. 6 is a front view of the hard disk drive fixing device 11 according to the first embodiment in which the hard disk drive is accommodated in the fixed state. The joint portion 25 that couples the rotational distal ends of the pair of retaining portions 23 includes the lock claw 55. In the hard disk drive fixing device 11, when the retaining portion 23 is rotated about the hinge portion 51, the engaging plate portion 59 of the joint portion 25 is disposed inside the front wall portion 35, and the engaging plate coupling portions 61 on both sides sandwiching the engaging plate portion 59 are disposed outside the front wall portion 35. The lock claw 55 at the end extending downward of the engaging plate portion 59 disposed inside the front wall portion 35 is engaged with the front wall portion 35 from the inside of the accommodation space 27. Accordingly, the pair of retaining portions 23 are simultaneously fixed to the case main body 21.

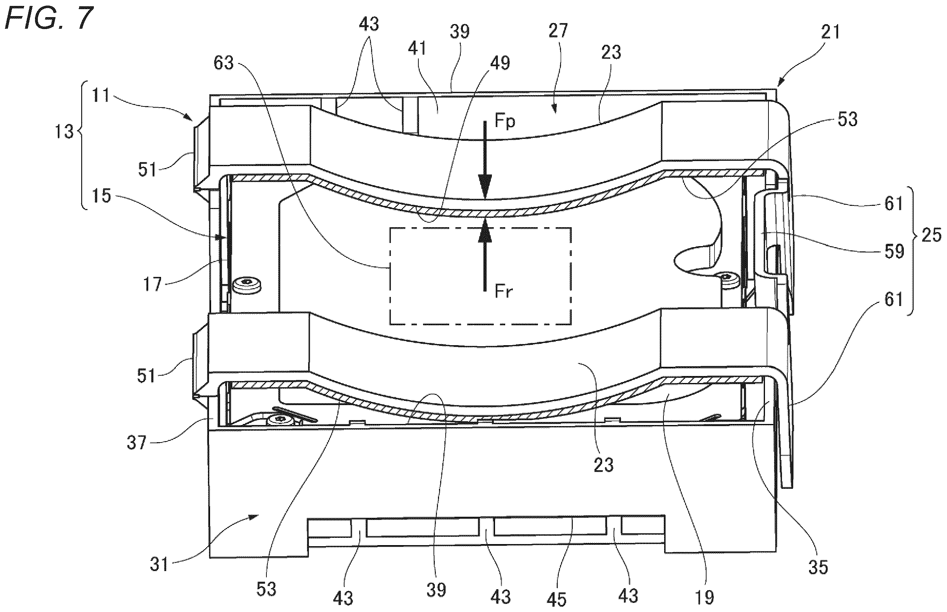

FIG. 7 is a perspective view of the hard disk drive fixing device 11 according to the first embodiment in which the hard disk drive is accommodated in the fixed state. In the hard disk drive fixing device 11, in the state in which the retaining portion 23 is fixed to the case main body 21, the curved surface 49 of the retaining portion 23 protrudes into the accommodation space 27. Accordingly, the upper surface of the hard disk drive 15 accommodated in the accommodation space 27 is pressed by a force Fp applied to the curved surfaces 49 of the pair of retaining portions 23 in a direction of gravity. That is, movement of the hard disk drive 15 in a direction parallel to the bottom wall portion 29 is restricted by the peripheral wall portion 31, and the hard disk drive 15 is clamped in the housing height direction of the hard disk drive between the bottom wall portion 29 and the retaining portion 23 and is firmly fixed to the hard disk drive fixing device 11.

In the hard disk drive fixing device 11, the joint portion 25 that couples the pair of retaining portions 23 is provided at the rotational distal ends of the retaining portions 23, and thus the pair of retaining portions 23 can be fixed to the case main body 21 by one lock claw 55 by simultaneously rotating the pair of retaining portions 23 and engaging the lock claw 55 of the joint portion 25 with the front wall portion 35. In addition, by releasing the engagement of the one lock claw 55 with the front wall portion 35, the fixing achieved by the pair of retaining portions 23 can be released at once. In this way, with the hard disk drive fixing device 11, the hard disk drive 15 can be easily attached and detached by one touch as compared with a related fixing structure in which engaging and engagement releasing operations are performed individually at a plurality of positions.

In addition, since the case main body 21, the pair of retaining portions 23, and the joint portion 25 that couples the rotational distal ends of the pair of retaining portions 23 are integrally molded with a resin material, only one molding die is required and a member cost can be reduced as compared with a related fixing structure that requires separate components.

Further, since two separated portions of the hard disk drive 15 can be simultaneously pressed toward the bottom wall portion 29 by the pair of parallel retaining portions 23, the hard disk drive 15 can be stably fixed as compared with a related fixing structure in which a center of the upper surface of the hard disk drive 15 is pressed at one portion.

When the fixed object is the hard disk drive 15, both sides of the casing of the hard disk drive 15 sandwiching a disk rotation axis can be pressed by the retaining portions 23, and thus malfunctions of the hard disk drive 15 caused by applying a pressure load to the disk rotation shaft is generally disposed in a center of the casing can be prevented. Further, by retaining the casing by the pair of separated retaining portions 23, a product display label 63 adhered to a center of an upper surface of the casing can be easily viewed.

In the hard disk drive fixing device 11, the cushion material 53 that comes into contact with the fixed object is adhered to at least a part of the bottom wall portion 29 and the retaining portion 23.

In the hard disk drive fixing device 11, the cushion material 53 is adhered to the bottom wall portion 29 and the retaining portion 23. The cushion material 53 is adhered to at least a part of the bottom wall portion 29 and the retaining portion 23 that come into contact with the hard disk drive 15. That is, the cushion material 53 is interposed between the hard disk drive 15 and portions of the bottom wall portion 29 and the retaining portion 23 that come into contact with the hard disk drive 15. The cushion material 53 may be collectively adhered to a portion that does not come into contact with the hard disk drive 15 in consideration of adhesion workability.

The cushion material 53 attenuates vibration and impact transmitted between the hard disk drive fixing device 11 and the hard disk drive 15. Accordingly, the hard disk drive fixing device 11 can prevent malfunctions such as seek caused by vibration of the hard disk drive itself or external vibration or impact.

In the hard disk drive fixing device 11, the bottom wall portion 29 is formed in a square shape, and the vent hole 45 for opening the accommodation space 27 to the outside is drilled in the bottom wall portion 29 and four corner portions 47 at which the four sides of the bottom wall portion 29 intersect with the peripheral wall portion 31.

In the hard disk drive fixing device 11, the bottom wall portion 29 is formed in a square shape. In the case main body 21, the vent hole 45 (see FIG. 2) is formed in the bottom wall portion 29 formed in a square shape. In the case main body 21, the vent hole 45 is also formed in four corner portions 47 at which the four sides of the bottom wall portion 29 intersect with the peripheral wall portion 31. Accordingly, air in the accommodation space 27 warmed by the hard disk drive 15 can be discharged not only from the upper opening of the peripheral wall portion 31 but also from the bottom wall portion 29 and the peripheral wall portion 31.

Regardless of whether the hard disk drive fixing device 11 is used at a horizontal position at which the bottom wall portion 29 is parallel to a placement surface or at a vertical position at which the bottom wall portion 29 is perpendicular to the placement surface, air in the accommodation space 27 can be sucked and exhausted by natural convection (that is, high-temperature air can be exhausted from the upper vent hole 45 and low-temperature outside air can be introduced into the accommodation space 27 from the lower vent hole 45), and the hard disk drive 15 can be efficiently cooled.

In the hard disk drive fixing device 11, the plurality of ribs 43 that protrude into the accommodation space 27 and come into contact with the hard disk drive 15 are provided on the inner wall surface 41 of the peripheral wall portion 31.

In the hard disk drive fixing device 11, the hard disk drive 15 placed on the bottom wall portion 29 of the case main body 21 is surrounded by the peripheral wall portion 31. The front wall portion 35, the rear wall portion 37, and the pair of side wall portions 39 constituting the peripheral wall portion 31 each include the rib 43 (see FIG. 2) protruding from the surface facing the accommodation space. When the hard disk drive 15 is in contact with the rib 43, movement in the direction parallel to the bottom wall portion 29 is restricted. A gap corresponding to the protrusion of the rib 43 is secured between the inner wall surface 41 of the peripheral wall portion 31 and an outer peripheral surface of the hard disk drive 15. Accordingly, the hard disk drive 15 can effectively dissipate heat from the outer peripheral surface facing the inner wall surface 41 of the peripheral wall portion 31. In the hard disk drive fixing device 11, heat can be dissipated from almost all outer surfaces of the hard disk drive 15 accommodated in the accommodation space 27 of the case main body 21. As a result, it is possible to prevent malfunctions caused by the hard disk drive 15 becoming too hot due to heat buildup caused by heat generation.

In the hard disk drive fixing device 11, the vent hole 45 formed in the corner portion 47 at which the bottom wall portion 29 intersects with the front wall portion 35 includes a flexible space for the lock claw 55 of the joint portion 25 to be engaged with the front wall portion 35.

In the hard disk drive fixing device 11, during a fixing operation of the hard disk drive 15, the joint portion 25 that couples the rotational distal ends of the pair of retaining portions 23 is rotated in a direction approaching the front wall portion 35. When the lock claw 55 provided on the engaging plate portion 59 of the joint portion 25 is engaged with the front wall portion 35, the curved surfaces 49 of the pair of retaining portions 23 each protrude into the accommodation space 27.

When the hard disk drive 15 is accommodated in the accommodation space 27, the curved surface 49 presses the upper surface of the hard disk drive 15 with the force Fp. Since the hard disk drive 15 is placed on the bottom wall portion 29, an upward reaction force Fr (see FIG. 7) acts from the hard disk drive 15 on the retaining portion 23 that presses the hard disk drive 15. The retaining portion 23 is elastically deformed due to this reaction force Fr in a direction in which the curvature of the curved surface 49 is reduced. An elastic restoring force in a direction in which the curvature of the curved surface 49 increases is accumulated in the elastically deformed retaining portion 23. The lock claw 55 is engaged with a lower end of the front wall portion 35 with a strong engaging force by the elastic restoring force.

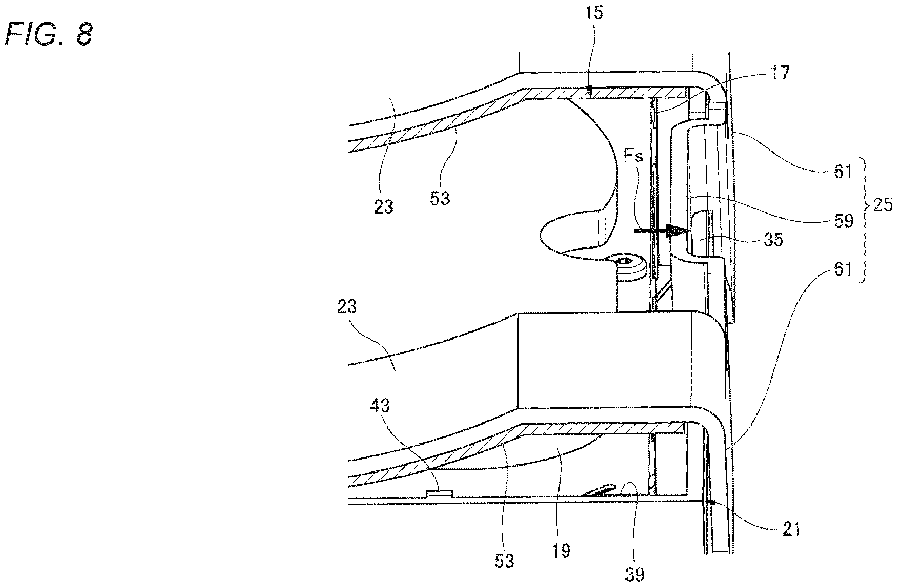

FIG. 8 is an enlarged view of a main portion illustrated in FIG. 7. The elastic restoring force accumulated in the retaining portion 23 due to the elastic deformation of the curved surface 49 includes a component force Fs in a direction of pressing the engaging plate portion 59 of the joint portion 25 against the front wall portion 35. Accordingly, the lock claw 55 provided on the engaging plate portion 59 is biased in a direction in which the lock claw 55 is to be engaged with the front wall portion 35 and is locked more firmly.

The hard disk drive 15 has at least two types of sizes with different heights from the bottom wall portion 29. The curved surface 49 of the retaining portion 23 that protrudes into the accommodation space 27 is formed with a protruding amount that allows the curved surface 49 to press against the upper surface of the hard disk drive 15 even when the hard disk drive 15 is low. Therefore, when a high hard disk drive 15 is accommodated in the accommodation space 27, the curved surface 49 of the retaining portion 23 is deformed more greatly. That is, a larger elastic restoring force in a direction of pushing up the retaining portion 23 is accumulated in the retaining portion 23. The high hard disk drive 15 has a larger mass than the low hard disk drive 15. In the hard disk drive fixing device 11, when the hard disk drive 15 having a larger mass is fixed, a larger engaging force acts on the lock claw 55. That is, the engaging force can be increased in accordance with the mass of the hard disk drive 15.

When the lock claw 55 is to be inserted into the inside of the front wall portion 35, the lock claw 55 comes into contact with the inner wall surface 41 of the front wall portion 35 and bends the engaging plate portion 59 in a direction away from the inner surface. When the locking claw 55 enters the vent hole 45 and reaches the lower end of the front wall portion 35, the locking claw 55 reaches a lower side of the front wall portion 35 and is engaged therewith, and simultaneously the engaging plate portion 59 comes into contact with the inner wall surface 41 of the front wall portion 35. Therefore, before the lock claw 55 reaches the lower end of the front wall portion 35, the engaging plate portion 59 bends and protrudes toward the accommodation space by the protrusion of the lock claw 55. The vent hole 45 has a size allowing reception of the engaging plate portion 59 bent toward the accommodation space. That is, the vent hole 45 is formed to include the flexible space for the lock claw 55 to be engaged with the front wall portion 35.

Accordingly, the hard disk drive fixing device 11 enables the joint portion 25 to be engaged with the front wall portion 35 without forming another shape portion by effectively using the vent hole 45 for cooling the hard disk drive 15. That is, the vent hole 45 formed in the corner portion 47 between the bottom wall portion 29 and the front wall portion 35 serves both as a cooling unit for the hard disk drive 15 and as an engaging unit for the locking claw 55.

The storage device 13 according to the first embodiment includes the hard disk drive fixing device 11 and the hard disk drive serving as the fixed object to be fixed to the hard disk drive fixing device 11.

In the storage device 13 according to the first embodiment, the hard disk drive 15 is placed on the case main body 21 of the hard disk drive fixing device 11 attached to the housing, and thus the hard disk drive 15 can be easily attached and detached by simply rotating the pair of retaining portions 23 whose rotational proximal ends are connected to the rear wall portion 37 via the hinge portions 51. The rotation of the pair of retaining portions 23 can be performed simultaneously with the joint portion 25 that couples the rotational distal ends of the pair of retaining portions 23 to each other. In addition, in the storage device 13, the hard disk drive fixing device 11 is implemented by a single member, and thus the member cost can be reduced. Further, in the storage device 13, the hard disk drive fixing device 11 can realize fixing without rattling, that is, stable fixing of the hard disk drive 15 by the pressing and clamping performed by the pair of retaining portions 23 and the bottom wall portion 29 and a fitting structure implemented by the peripheral wall portion 31 (the side wall portions 39, the front wall portion 35, and the rear wall portion 37).

Therefore, according to the hard disk drive fixing device 11 of the first embodiment, the fixed object can be easily attached and detached, and the fixed object can be stably fixed with a low member cost.

In addition, according to the storage device 13 of the first embodiment, the hard disk drive 15 can be easily attached and detached, and the hard disk drive 15 can be stably fixed with a low member cost.

### <Modification>

Hereinafter, a modification of the hard disk drive fixing device according to the first embodiment of the present disclosure will be described with reference to the drawings. The same configurations as those described in the first embodiment are denoted by the same reference numerals, and the description thereof is omitted. In addition, in the configurations illustrated in the modification that are given the same reference numerals as those in the first embodiment, the number, position, size and shape of the configurations (for example, the rib 43, the vent hole 45, or the screw hole) are merely examples and are not limited thereto. In the modification, illustration and description of the cushion material 53 are omitted.

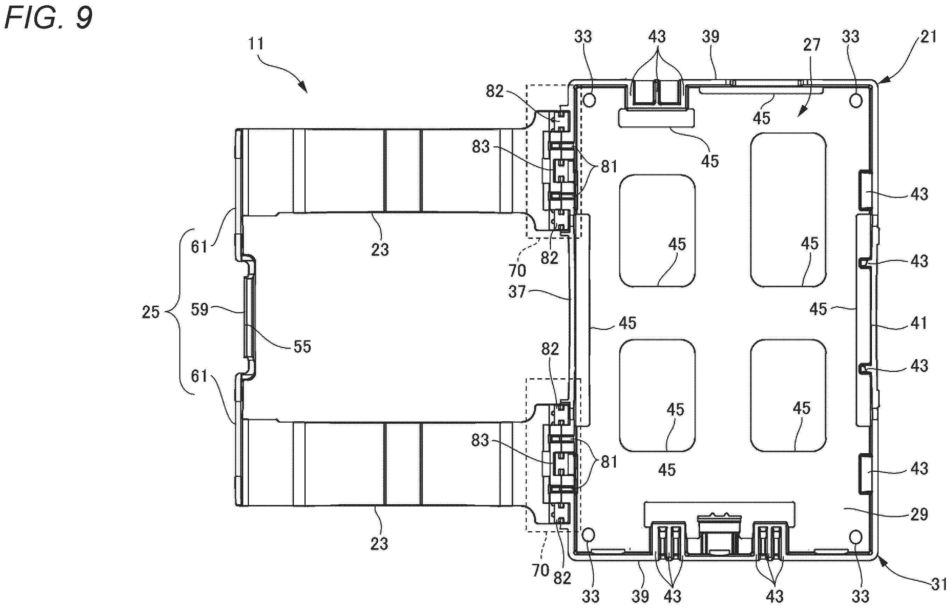

FIG. 9 is a plan view of a hard disk drive fixing device according to the modification in which a hard disk drive is removed.

Each of the retaining portions 23 is connected to the rear wall portion 37 by a second hinge portion 70 which is an example of a hinge portion. The pair of second hinge portions 70 are disposed, for example, in the vicinity of both ends of the rear wall portion 37 in a longitudinal direction. The second hinge portion 70 includes a pair of coupling portions 82 at both ends with a central hollow portion 83 as a center. A position relation between the central hollow portion 83 and the pair of coupling portions 82 in the second hinge portion 70 is merely an example, and the present invention is not limited thereto. The retaining portion 23 extends across the rear wall portion 37 and the front wall portion 35 by being rotated about the pair of coupling portions 82. The pair of retaining portions 23 extend across an upper opening of the peripheral wall portion 31 on a side opposite to the bottom wall portion 29. Each of the retaining portions 23 is formed in a plate shape elongated in a direction in which the retaining portion 23 extends across the rear wall portion 37 and the front wall portion 35.

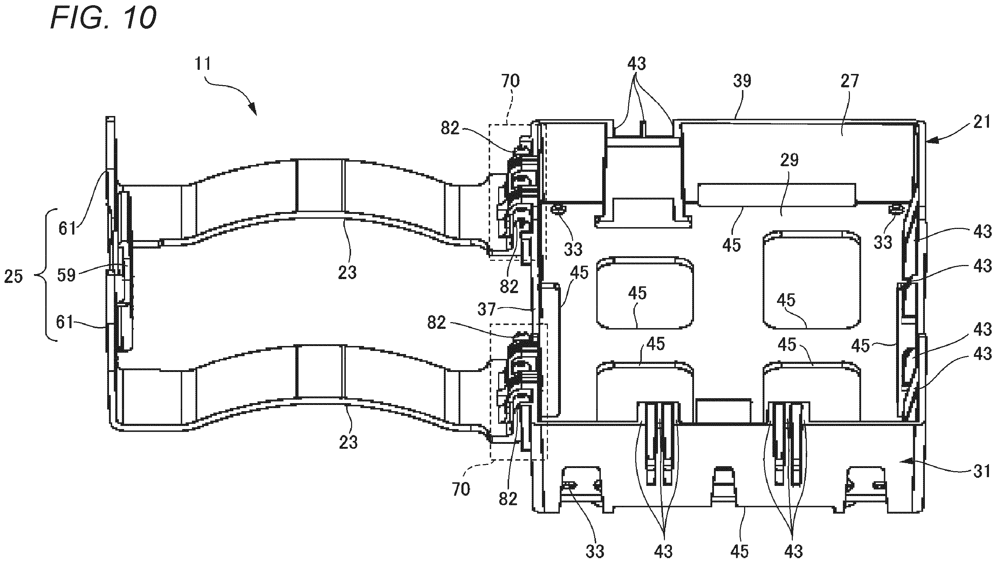

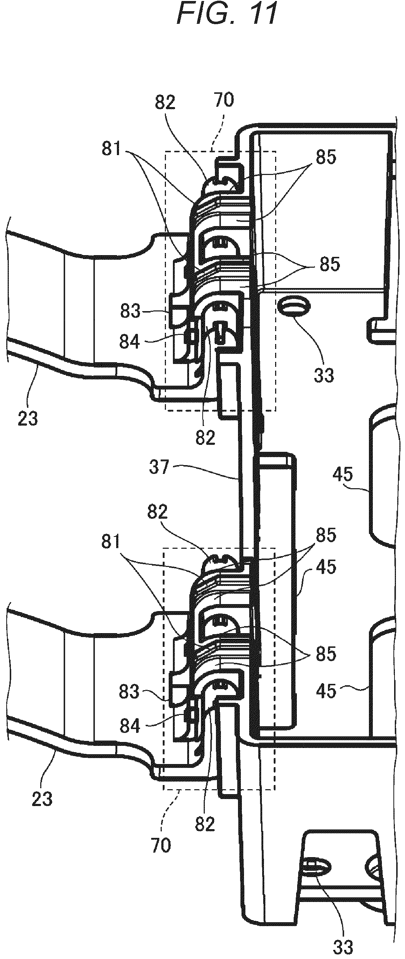

Next, a configuration of the second hinge portion will be described with reference to FIGS. 10 and 11. FIG. 10 is a perspective view of the hard disk drive fixing device illustrated in FIG. 9 in which the hard disk drive is removed. FIG. 11 is an enlarged view of the second hinge portion of the hard disk drive fixing device illustrated in FIG. 10.

The second hinge portion 70 extends along the rear wall portion 37 toward the bottom wall portion 29 from an upper end of the rear wall portion 37 (that is, an end portion of the rear wall portion 37 on a side opposite to the bottom wall portion 29).

The second hinge portion 70 includes a second protrusion 81 and a first contact surface 85 between the coupling portion 82 and the central hollow portion 83.

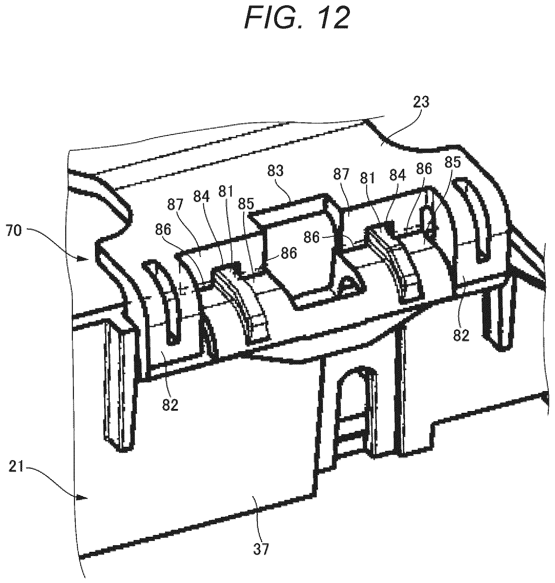

FIG. 12 is a perspective view of the second hinge portion of the hard disk drive fixing device according to the modification as viewed from an outside of the rear wall portion.

The first contact surface 85 is a surface extending from the upper end of the rear wall portion 37 to a side opposite to the accommodation space 27. When the first contact surface 85 is a curved surface, the first contact surface 85 extends from the upper end of the rear wall portion 37 toward the side opposite to the accommodation space 27 and downward (that is, extends from the upper end of the rear wall portion 37 toward the bottom wall portion 29 of the case main body 21). The first contact surface 85 is not limited to a curved surface, and may be formed as a flat surface, or may be formed as a flat surface and a curved surface.

The pair of second protrusions 81 are provided, for example, to protrude from the first contact surface 85 with the central hollow portion 83 sandwiched therebetween. Each second protrusion 81 is formed in a rectangular shape elongated in a direction opposite to the accommodation space 27 from the upper end of the rear wall portion 37.

The retaining portion 23 includes, on an end portion on a side opposite to the joint portion 25, the coupling portions 82, the central hollow portion 83, and a pair of second contact surfaces 87. The second contact surface 87 is a surface provided on the end portion of the retaining portion 23 on the side opposite to the joint portion 25. The central hollow portion 83 is provided on the end portion of the retaining portion 23 on the side opposite to the joint portion 25, and is formed by cutting out a part of the end portion of the retaining portion 23 on the side opposite to the joint portion 25 in a direction of the joint portion 25. The pair of second contact surfaces 87 are formed outside the central hollow portion 83 with the central hollow portion 83 sandwiched therebetween. The pair of coupling portions 82 are formed outside the respective second contact surfaces 87 with the central hollow portion 83 as the center. A position relation among the coupling portion 82, the second contact surface 87, and the central hollow portion 83 is merely an example, and the present invention is not limited thereto. The central hollow portion 83 may be omitted from the retaining portion 23.

A recess 84 is formed in the second contact surface 87. The recess 84 is formed by cutting out a part of the second contact surface 87 from a contact portion 86 side. The recess 84 is formed at a position at which the recess 84 is adjacent with the second protrusion 81 when the retaining portion 23 is rotated in a direction of covering the case main body 21. The recess 84 and the second protrusion 81 may be omitted from the hard disk drive fixing device 11.

The contact portion 86 is a surface that allows the first contact surface 85 and the second contact surface 87 to come into slidable contact with each other when the retaining portion 23 is rotated in the direction of covering the case main body 21. The first contact surface 85 and the second contact surface 87 may be in line contact with each other on the contact portion 86.

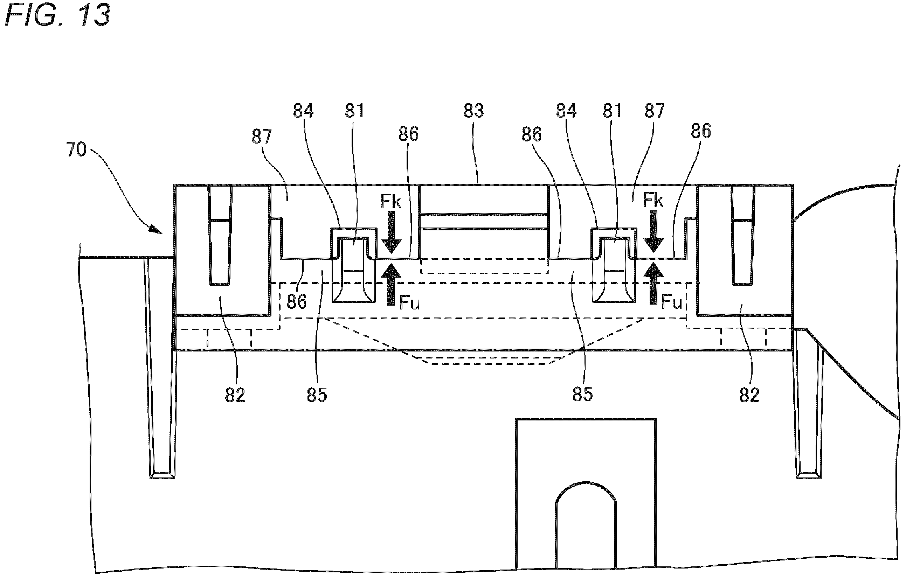

Next, an operation of the hard disk drive fixing device according to the above modification will be described. FIG. 13 is a front view of the second hinge portion of the hard disk drive fixing device according to the modification as viewed from the outside of the rear wall portion.

When the retaining portion 23 is rotated in the direction of covering the case main body 21 with the coupling portion 82 as an axis, and the first contact surface 85 and the second contact surface 87 come into contact with each other, a force Fk acts on the contact portion 86 serving as a contact surface in a direction from the retaining portion 23 to the case main body 21. That is, the first contact surface 85 is pressed by the force Fk from the second contact surface 87. When the first contact surface 85 is pressed by the force Fk from the second contact surface 87, a reaction force Fu acts on the contact portion 86 in a direction from the case main body 21 to the retaining portion 23. That is, the second contact surface 87 receives the reaction force Fu from the first contact surface 85.

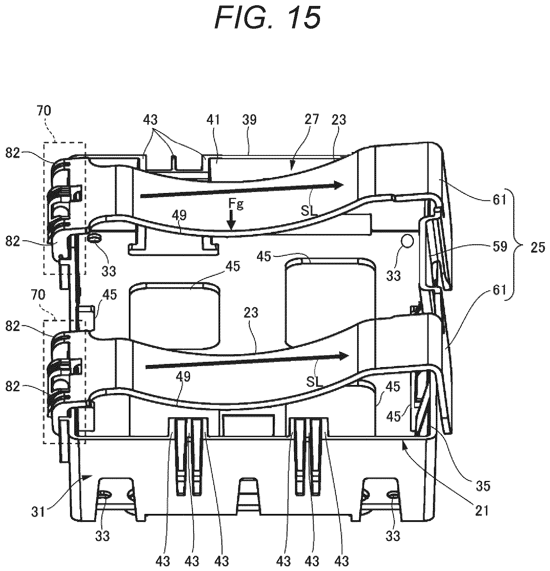

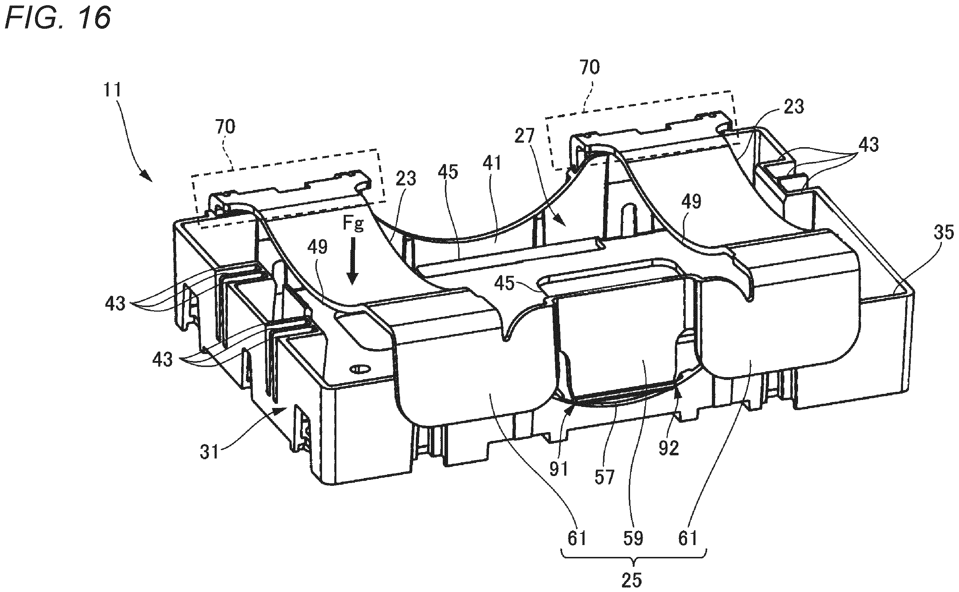

When the lock claw 55 is engaged with the front wall portion 35 from an inside of the accommodation space 27, the pair of retaining portions are fixed to the case main body 21 (see FIG. 4). Meanwhile, when the engaging plate portion 59 is to be inserted into the front wall portion 35 from the outside of the accommodation space 27, the second contact surface 87 receives the reaction force Fu from the first contact surface 85, which causes the retaining portion 23 to rotate in a direction of opening from the case main body 21 with the second hinge portion 70 as an axis, and results in a disengaged state in which the lock claw 55 is not engaged with the front wall portion 35 (see FIGS. 15 and 16).

The first contact surface 85 and the second contact surface 87 may come into contact with each other by the contact between the recess 84 and the second protrusion 81 instead of the contact portion 86. When the recess 84 and the second protrusion 81 come into contact with each other, a force (not illustrated) from the second protrusion 81 toward the recess 84 acts on a contact surface between the recess 84 and the second protrusion 81, which results in the disengaged state.

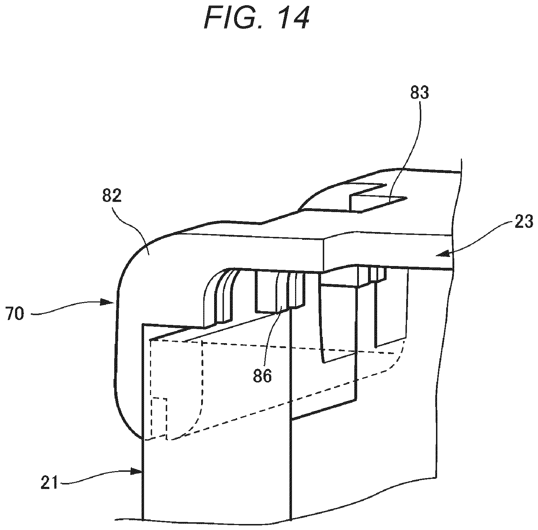

FIG. 14 is a perspective view of the second hinge portion of the hard disk drive fixing device according to the modification as viewed from an outside of the peripheral wall portion. When the retaining portion 23 is rotated in the direction of covering the case main body 21, the retaining portion 23 and the case main body 21 come into contact with each other at the contact portion 86.

FIG. 15 is a perspective view of the hard disk drive fixing device in the disengaged state in which the retaining portions are not engaged with the case main body.

In the hard disk drive fixing device 11 illustrated in FIG. 15, the retaining portion 23 is rotated in the direction of covering the case main body 21 with the second hinge portion 70 as a rotation axis and is in the disengaged state.

In the disengaged state, a force Fg of gravity acts on the retaining portion 23. When the retaining portion 23 is in the disengaged state, the joint portion 25 on a rotational distal end is positioned higher relative to a placement surface of the hard disk drive fixing device 11 than the second hinge portion 70 on a rotational proximal end as viewed from a direction of the side wall portion 39 of the case main body 21. That is, the retaining portion 23 is inclined in a direction of an inclination SL when viewed from the direction of the side wall portion 39 of the case main body 21 in the disengaged state.

FIG. 16 is a perspective view of the hard disk drive fixing device in the disengaged state in which the retaining portions are not engaged with the case main body, as viewed from an outside of the front wall portion.

The hard disk drive fixing device 11 illustrated in FIG. 16 is in the disengaged state. When the hard disk drive fixing device 11 is in the disengaged state, the engaging plate portion 59 and the recessed portion 57 are in point contact with each other at two points of a first end point 91 and a second end point 92. Accordingly, the engaging plate portion 59 does not enter the accommodation space 27 inside the front wall portion 35 in the disengaged state. That is, the retaining portion 23 is inclined when viewed from the direction of the side wall portion 39 of the case main body 21 in the disengaged state. Accordingly, in the hard disk drive fixing device 11, the engaging plate portion 59 can be prevented from entering the accommodation space 27 inside the front wall portion 35 in the disengaged state.

As described above, the second hinge portion 70 of the hard disk drive fixing device 11 according to the modification includes the contact portion 86 that allows the first contact surface 85, which is a surface extending from the upper end of the rear wall portion 37 to the side opposite to the accommodation space 27, and the second contact surface 87 provided on the end portion of the retaining portion 23 on the side opposite to the joint portion 25 to come into slidable contact with each other. Accordingly, the retaining portion 23 of the hard disk drive fixing device 11 can smoothly rotate with the second hinge portion 70 as an axis.

In the hard disk drive fixing device 11 according to the modification, when the lock claw 55 is to be inserted into the outside of the front wall portion 35, the reaction force from the first contact surface 85 toward the second contact surface 87 acts on the contact portion 86, and the joint portion 25 is in the disengaged state of not being engaged with the front wall portion 35. Accordingly, in the hard disk drive fixing device 11 according to the modification, a manufacturer, a transporter, a user or the like can easily determine whether the hard disk drive fixing device 11 is in the disengaged state. The hard disk drive fixing device 11 can be prevented from being damaged due to the retaining portion 23 accidentally moving during production, transportation, or use of the hard disk drive fixing device 11. For example, the hard disk drive fixing device 11 can be transported in the disengaged state to prevent the retaining portion 23, the second hinge portion 70, and the like from being damaged.

The case main body 21 of the hard disk drive fixing device 11 according to the modification includes, at a substantially central portion of the front wall portion 35, the recessed portion 57 formed by cutting out in a concave curve shape from the upper portion. The joint portion 25 of the hard disk drive fixing device 11 includes the engaging plate portion 59 that couples the rotational distal ends of the pair of retaining portions 23. When the joint portion 25 is in the disengaged state, the engaging plate portion 59 is in point contact with the recessed portion 57 at two points. Accordingly, the hard disk drive fixing device 11 according to the modification can prevent the engaging plate portion 59 from entering the inside of the accommodation space 27 when the hard disk drive fixing device 11 is in the disengaged state.

The first contact surface 85 of the hard disk drive fixing device 11 according to the modification is a curved surface. Accordingly, in the hard disk drive fixing device 11 according to the modification, the first contact surface 85 and the second contact surface 87 can smoothly slide.

When the retaining portion 23 of the hard disk drive fixing device 11 according to the modification is viewed from the direction of the side wall portion 39 of the case main body 21 in the disengaged state, the joint portion 25 on the rotational distal end is positioned higher from the placement surface of the hard disk drive fixing device 11 than the second hinge portion 70 on the rotational proximal end. Accordingly, in the hard disk drive fixing device 11 according to the modification, a manufacturer, a transporter, a user or the like can easily determine the disengaged state.

The second hinge portion 70 of the hard disk drive fixing device 11 according to the modification includes the recess 84 provided on the end portion of the retaining portion 23 on the rear wall portion 37 and the second protrusion 81 provided in a manner of protruding toward the side of the rear wall portion 37 opposite to the accommodation space 27 of the case main body 21. Accordingly, the hard disk drive fixing device 11 according to the modification can be brought into the disengaged state by bringing the recess 84 into contact with the second protrusion 81.

In the hard disk drive fixing device 11 according to the modification, when the lock claw 55 is to be inserted into the outside of the front wall portion 35 and the recess 84 and the second protrusion 81 come into contact with each other, the reaction force from the second protrusion 81 toward the recess 84 acts on the contact surface at which the recess 84 and the second protrusion 81 come into contact with each other, and the joint portion 25 is in the disengaged state of not being engaged with the front wall portion 35. Accordingly, in the hard disk drive fixing device 11 according to the modification, a manufacturer, a transporter, a user or the like can easily determine whether the hard disk drive fixing device 11 is in the disengaged state.

Although various embodiments have been described above with reference to the accompanying drawings, the present disclosure is not limited to such examples. It is apparent to a person skilled in the art that various changes, modifications, substitutions, additions, deletions, and equivalents can be conceived within the scope of the claims, and it is understood that such modifications also belong to the technical scope of the present disclosure. The components in the various embodiments described above may be optionally combined without departing from the gist of the invention.

The present application is based on Japanese Patent Application (Japanese Patent Application No. 2022-080371) filed on May 16, 2022, and the contents thereof are incorporated herein by reference.

### INDUSTRIAL APPLICABILITY

The present disclosure is useful as a fixing device and a storage device that facilitates attachment and detachment of a fixed object and realizes stable fixing of the fixed object with a low member cost.

### REFERENCE SIGNS LIST

11: hard disk drive fixing device
13: storage device
15: hard disk drive (fixed object)
21: case main body
23: retaining portion
25: joint portion
27: accommodation space
29: bottom wall portion
31: peripheral wall portion
35: front wall portion
37: rear wall portion
41: inner wall surface
43: rib
45: vent hole
47: corner portion
49: curved surface
51: hinge portion
53: cushion material
55: lock claw

## Claims

1. A fixing device comprising:
a case main body including, inside a peripheral wall portion standing from a bottom wall portion, an accommodation space configured to accommodate a fixed object;
a pair of retaining portions rotatably connected to the case main body and extending across an upper opening of the peripheral wall portion on a side opposite to the bottom wall portion; and
a joint portion coupling rotational distal ends of the pair of retaining portions, wherein
the peripheral wall portion includes a front wall portion and a rear wall portion facing each other with the accommodation space sandwiched therebetween,
the pair of retaining portions each have a curved surface protruding into the accommodation space, and have a rotational proximal end connected to the rear wall portion by a hinge portion, and
the joint portion includes a lock claw configured to be engaged with the front wall portion from an inside of the accommodation space.

2. The fixing device according to claim 1, wherein
a cushion material configured to come into contact with the fixed object is adhered to at least a part of the bottom wall portion and the retaining portion.

3. The fixing device according to claim 1 or 2, wherein
the bottom wall portion is formed in a square shape, and
a vent hole configured to open the accommodation space to outside is drilled in the bottom wall portion and in four corner portions at which four sides of the bottom wall portion intersect with the peripheral wall portion.

4. The fixing device according to claim 3, wherein
an inner wall surface of the peripheral wall portion is provided with a plurality of ribs that protrude into the accommodation space and come into contact with the fixed object.

5. The fixing device according to claim 3, wherein
the vent hole formed in the corner portion at which the bottom wall portion intersects with the front wall portion includes a flexible space for the lock claw of the joint portion to be engaged with the front wall portion.

6. The fixing device according to claim 1, wherein
the hinge portion includes a contact portion configured to allow a first contact surface and a second contact surface to come into slidable contact with each other, the first contact surface being a surface extending from an upper end of the rear wall portion toward a side opposite to the accommodation space, and a second contact surface being provided on an end portion of the retaining portion on a side opposite to the joint portion.

7. The fixing device according to claim 6, wherein
when the lock claw is inserted into an outside of the front wall portion, a reaction force from the first contact surface toward the second contact surface acts on the contact portion, and the joint portion is in a disengaged state of not being engaged with the front wall portion.

8. The fixing device according to claim 7, wherein
the case main body includes, at a substantially central portion of the front wall portion, a recessed portion formed by cutting out in a concave curved shape from an upper portion,
the joint portion includes an engaging plate portion that couples the rotational distal ends of the pair of retaining portions, and
when the joint portion is in the disengaged state, the engaging plate portion is in point contact with the recessed portion at two points.

9. The fixing device according to claim 6, wherein
the first contact surface is a curved surface.

10. The fixing device according to claim 7, wherein
when the retaining portion is viewed from a side wall portion direction of the case main body in the disengaged state, the joint portion on the rotational distal end is positioned higher relative to a placement surface of the fixing device than the hinge portion on the rotational proximal end as viewed from a direction of the side wall portion of the case main body.

11. The fixing device according to claim 1, wherein
the hinge portion includes a recess provided on an end portion of the retaining portion on the rear wall portion and a protrusion provided in a manner of protruding toward a side of the rear wall portion opposite to the accommodation space of the case main body.

12. The fixing device according to claim 11, wherein
when the lock claw is inserted into an outside of the front wall portion and the recess and the protrusion come into contact with each other, a reaction force from the protrusion toward the recess acts on a contact surface at which the recess and the protrusion come into contact with each other, and the joint portion is in a disengaged state of not being engaged with the front wall portion.

13. A storage device comprising:
the fixing device according to claim 1; and
a storage medium that is the fixed object to be fixed to the fixing device.
